(19) Europäisches Patentamt
European Patent Office
Office européen des brevets

(11) **EP 4 756 926 A1**

(12) **EUROPEAN PATENT APPLICATION**
published in accordance with Art. 153(4) EPC

(43) Date of publication:
**10.06.2026 Bulletin 2026/24**

(21) Application number: **24849531.9**

(22) Date of filing: **26.07.2024**

(51) International Patent Classification (IPC):
*H01M 4/525* (2010.01)   *H01M 4/131* (2010.01)
*H01M 4/1391* (2010.01)   *C01G 53/00* (2025.01)
*H01M 10/052* (2010.01)   *C30B 29/22* (2006.01)

(52) Cooperative Patent Classification (CPC):
**C01G 53/00; C30B 29/22; H01M 4/131;
H01M 4/1391; H01M 4/525; H01M 10/052;
Y02E 60/10**

(86) International application number:
**PCT/KR2024/010985**

(87) International publication number:
**WO 2025/028962 (06.02.2025 Gazette 2025/06)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **31.07.2023 KR 20230099915**

(71) Applicant: Posco Future M Co., Ltd.
**Pohang-si, Gyeongsangbuk-do 37918 (KR)**

(72) Inventors:
• **PARK, Jeonghyeon**
  **Pohang-si, Gyeongsangbuk-do 37918 (KR)**

• **LIM, Seokjae**
  **Pohang-si, Gyeongsangbuk-do 37918 (KR)**
• **SEO, Sunghwa**
  **Pohang-si, Gyeongsangbuk-do 37918 (KR)**
• **KIM, Jaehan**
  **Pohang-si, Gyeongsangbuk-do 37918 (KR)**
• **CHOI, Kwonyoung**
  **Pohang-si, Gyeongsangbuk-do 37918 (KR)**

(74) Representative: **Meissner Bolte Partnerschaft
mbB
Patentanwälte Rechtsanwälte
Postfach 86 06 24
81633 München (DE)**

(54) **CATHODE ACTIVE MATERIAL FOR LITHIUM SECONDARY BATTERY, MANUFACTURING METHOD OF SAME, AND LITHIUM SECONDARY BATTERY COMPRISING SAME**

(57) The present invention relates to a positive electrode active material for a lithium secondary battery, the positive electrode active material comprising a single-particle lithium transition metal oxide containing from 50 mol% to 70 mol% of nickel based on a total moles of transition metals, and satisfying Equation 1 below.

[Equation 1]

$$Dv50 / Dn50 \geq 3.0$$

In Equation 1, Dv50 is a volume-based average particle diameter of the positive electrode active material, and Dn50 is a number-based average particle diameter of the positive electrode active material.

【Fig. 1】

EP 4 756 926 A1

**Description**

[Technical Field]

The present invention relates to a positive electrode active material for a lithium secondary battery, a method for preparing the same, and a lithium secondary battery including the positive electrode active material. More particularly, the present invention relates to a method for preparing a single-particle positive electrode active material for a lithium secondary battery, the positive electrode active material prepared thereby, and a lithium secondary battery including the same.

[Background Art]

A lithium secondary battery generates electrical energy by oxidation and reduction reactions that occur during insertion and de-insertion (intercalation and deintercalation) of lithium ions at a positive electrode and a negative electrode, while an organic or polymer electrolyte is present between the positive and negative electrodes.

Positive electrode active materials used in lithium secondary batteries include lithium cobalt oxide ($LiCoO_2$), lithium nickel oxide ($LiNiO_2$), lithium manganese oxides ($LiMnO_2$ or $LiMn_2O_4$), and lithium iron phosphate compounds ($LiFePO_4$). Among these, lithium cobalt oxide ($LiCoO_2$) has been widely used because it provides a high operating voltage and excellent capacity characteristics, and thus has been applied as a high-voltage positive electrode active material. However, due to rapid price increases and supply instability of cobalt (Co), the use of $LiCoO_2$ as a large-scale power source-such as in electric vehicles-has become limited, creating a need for alternative positive electrode active materials.

As an alternative, lithium transition metal composite oxides in which a portion of cobalt (Co) is substituted with nickel (Ni) and manganese (Mn), commonly referred to as nickel-cobalt-manganese (NCM) lithium composite transition metal oxides, have been developed. However, conventionally developed NCM composite oxides typically have a secondary particle morphology in which multiple primary particles are agglomerated. Such structures exhibit large specific surface areas, low particle strength, and high contents of lithium side-reaction products; therefore, they suffer from significant gas generation during cell operation, leading to degradation in battery lifetime and stability.

Accordingly, there has been growing interest in the development of positive electrode active materials having a *single-particle morphology,* rather than a secondary particle structure.

[Disclosure of the Invention]

[Technical Problem]

In view of the above, an aspect of the present invention is to provide a positive electrode active material for a lithium secondary battery in the form of a single-particle lithium transition metal oxide, which exhibits improved capacity characteristics and enhanced high-temperature cycle life. Another aspect of the invention is to provide a method for preparing the positive electrode active material, and a lithium secondary battery including the same.

[Technical Solution]

According to an embodiment of the present invention, there is provided a positive electrode active material for a lithium secondary battery comprising a single-particle lithium transition metal oxide containing from 50 to 70 mol% of nickel based on the total moles of transition metals, and satisfying Equation 1 below:

$$[Equation\ 1]$$

$$Dv_{50} / Dn_{50} \geq 3.0$$

In Equation 1, $Dv_{50}$ represents the volume-based average particle diameter of the lithium transition metal oxide, and $Dn_{50}$ represents the number-based average particle diameter of the lithium transition metal oxide.

The positive electrode active material may further satisfy Equation 2 below:

$$[Equation\ 2]$$

$$Dv_{50} - Dn_{50} \geq 2.5\ nm$$

In Equation 2, $Dv_{50}$ and $Dn_{50}$ are as defined above.

The volume-based average particle diameter ($Dv_{50}$) of the lithium transition metal oxide may be from 3.5 to 4.5 $\mu$m.

The number-based average particle diameter ($Dn_{50}$) of the lithium transition metal oxide may be 1 $\mu$m or less.

The crystallite size of the lithium transition metal oxide may be 190 nm or less.

The ratio of the c-axis lattice constant to the a-axis lattice constant (Lc/La) of the lithium transition metal oxide may be 4.955 or greater.

The c-axis lattice constant (Lc) may be 14.2472 nm or greater.

The a-axis lattice constant (La) may be 2.8752 nm or less.

The lithium transition metal oxide may be represented by Chemical Formula 1 below:

[Chemical Formula 1] $\quad\quad Li_a[Ni_xCo_yMn_zM_w]O_2$

wherein $0.8 \leq a \leq 1.2$, $0.5 \leq x \leq 0.7$, $0 \leq y \leq 0.2$, $0 \leq z \leq 0.4$, $0 \leq w \leq 0.2$, and $x + y + z + w = 1$, and M is one or more selected from Zr, Al, B, Y, Mg, Ti, Nb, W, Sc, Si, V, Fe, Mo, Ce, Hf, Ta, La, and Sr.

Another embodiment of the present invention provides a method for preparing a positive electrode active material for a lithium secondary battery, the method comprising: preparing a transition metal precursor containing from 50 to 70 mol% of nickel based on total transition metal moles; mixing the transition metal precursor with a lithium raw material, and performing a first calcination and a second calcination to form a lithium transition metal oxide; and performing primary crushing and secondary crushing of the lithium transition metal oxide to form a single-particle lithium transition metal oxide, wherein the second calcination is performed in an oxygen ($O_2$) atmosphere.

The secondary crushing may be performed such that the volume-based average particle diameter ($Dv_{50}$) becomes 3.5 to 4.5 $\mu$m.

The primary crushing may be performed at a stirring speed of 15,000 to 20,000 rpm.

The secondary crushing may be performed at a crushing pressure of 3.5 to 4.5 bar.

The first calcination may be performed in an air atmosphere.

The first and second calcination processes may each independently be performed at a temperature of 900 to 960°C.

Another embodiment provides a positive electrode for a lithium secondary battery comprising the positive electrode active material described above.

A further embodiment provides a lithium secondary battery comprising the above positive electrode.

[Advantageous Effects]

The positive electrode active material according to embodiments of the present invention is provided in the form of a single-particle lithium transition metal oxide, and because the ratio of the volume-based average particle diameter to the number-based average particle diameter is appropriately controlled, the resulting material can exhibit enhanced capacity and improved electrode energy density. Moreover, the high-temperature cycle life of the lithium secondary battery can also be significantly improved.

[Brief Description of the Drawings]

FIG. 1 is an SEM image of the positive electrode active material prepared in Example 1.
FIG. 2 is an SEM image of the positive electrode active material prepared in Comparative Example 1.

[Modes for Carrying Out the Invention]

As used herein, the terms "first," "second," "third," and the like may be used to describe various components, elements, regions, layers, and/or sections, but are not limited thereto. Such terms are merely employed to distinguish one component, element, region, layer, or section from another. Therefore, a "first" component, element, region, layer, or section described below may be referred to as a "second" component, element, region, layer, or section without departing from the scope of the present invention.

Technical and scientific terms used herein are intended only for describing particular embodiments, and are not intended to limit the present invention. Singular expressions are intended to include the plural forms as well unless the context clearly indicates otherwise. The term "comprising" used in the specification is intended to specify the presence of stated features, integers, steps, operations, elements, and/or components, but does not preclude the presence or addition of one or more other features, integers, steps, operations, elements, and/or components.

When a component is described as being "on" or "over" another component, it may be disposed directly on the other component or intervening components may be present therebetween. In contrast, when a component is described as being "directly on" another component, no intervening component is present.

Unless otherwise defined, all technical and scientific terms used herein have the same meanings as commonly understood by one of ordinary skill in the art to which the present invention pertains. Terms defined in commonly used dictionaries shall be interpreted consistently with their meaning in the relevant technical literature and the disclosure herein, and shall not be interpreted in an idealized or overly formalistic manner unless explicitly defined otherwise.

Unless otherwise stated, "%" refers to weight percent (wt%), and 1 ppm corresponds to 0.0001 wt%.

In the Markush-type expressions used herein, the phrase "combinations thereof" means one or more combinations or mixtures selected from the group consisting of the listed components, and encompasses any combination including one or more of the listed components.

The following description of embodiments is provided to enable those skilled in the art to readily practice the invention. However, the present invention may be implemented in various different forms and is not limited to the embodiments set forth herein.

## 1. Positive Electrode Active Material

In one embodiment of the present invention, the positive electrode active material for a lithium secondary battery includes a single-crystal (single-particle) lithium transition metal oxide. Compared with conventional secondary particles, the single-particle active material exhibits a smaller specific surface area, thereby reducing gas generation caused by side reactions with the electrolyte. In addition, the higher mechanical strength of the single particles suppresses particle cracking during calendaring, and minimizes crack formation during repeated charge and discharge cycles. Accordingly, the single-particle structure provides superior lifetime characteristics and improved safety compared to secondary particles, and enables the implementation of electrodes with higher energy density.

As used herein, the term "single particle" refers to a particle composed of a single primary particle and a particle composed of an aggregate of 30 or fewer primary particles, and is employed to distinguish such structures from conventional secondary-particle active materials in which tens to hundreds of primary particles are agglomerated. In contrast, the term "secondary particle" refers to an agglomerated structure formed through physical or chemical bonding of tens to hundreds of primary particles, irrespective of any intentional assembly or agglomeration process.

In one embodiment, the lithium transition metal oxide includes nickel in an amount of from 50 to 70 mol% based on the total moles of transition metals. In conventional NCM (nickel-cobalt-manganese) positive electrode materials, increasing the nickel content improves capacity; however, an excessively high nickel content may cause thermal propagation issues and degrade thermal safety, and also increases manufacturing cost due to the high price of nickel. Accordingly, the nickel content in the lithium transition metal oxide of the present invention is adjusted within the above range to achieve an optimal balance between capacity, thermal safety, and economic feasibility.

However, producing a single-particle lithium transition metal oxide generally requires a higher calcination temperature than required for conventional secondary particles, which inherently leads to decreased capacity. The inventors of the present invention conducted extensive studies to address this issue and discovered that the capacity characteristics can be significantly improved by appropriately controlling the ratio of the volume-based average particle diameter (Dv50) to the number-based average particle diameter (Dn50). Furthermore, the inventors surprisingly found that the high-temperature lifetime characteristics are also improved under such conditions. Detailed explanations follow.

In one embodiment, the positive electrode active material satisfies Equation 1 below:

$$[\text{Equation 1}]$$

$$Dv50 \,/\, Dn50 \geq 3.0$$

where Dv50 is the volume-based average particle diameter of the lithium transition metal oxide, and Dn50 is the number-based average particle diameter of the lithium transition metal oxide. More specifically, Dv50 may be defined as the particle diameter corresponding to 50% of the cumulative volume distribution, and Dn50 may be defined as the particle diameter corresponding to 50% of the cumulative number distribution. The Dv50 and Dn50 values may be measured using, for example, a laser diffraction method.

In certain embodiments, the Dv50 / Dn50 value may be 3.5, 4.0, or 4.3 or greater, and may be 5.0 or 4.8 or less.

The positive electrode active material may further satisfy Equation 2 below:

[Equation 2]

$$Dv50 - Dn50 \geq 2.5 \text{ nm}$$

In certain embodiments, the Dv50 - Dn50 value may be 2.7 nm or 3.0 nm or greater, and may be 3.5 nm or 3.2 nm or less.

According to one embodiment of the present invention, by satisfying Equation 1 or Equation 2, the positive electrode active material for a lithium secondary battery can achieve not only improved capacity and electrode energy density, but also enhanced high-temperature lifetime characteristics.

More specifically, satisfying Equation 1 or Equation 2 may indicate that, within the overall particle size distribution, the number of small-diameter particles is relatively greater than the number of medium- or large-diameter particles. Accordingly, when the positive electrode is fabricated, the small-diameter particles may be positioned between the medium- or large-diameter particles, thereby improving the electrode calendaring density. In addition, the reduction in pore volume within the electrode decreases the lithium-ion diffusion path length, thereby increasing the lithium-ion diffusion rate. As a result, the electrode energy density, capacity, and initial coulombic efficiency can be favorably enhanced.

In addition, the inventors confirmed that, when the positive electrode active material satisfies Equation 1 or Equation 2, the high-temperature lifetime characteristics are also improved in addition to the aforementioned electrochemical characteristics. This appears to result from the reduction of pores within the electrode, which increases the lithium-ion diffusion rate, promotes electrochemical reactions, and reduces irreversible behavior.

However, when the value of Dv50/Dn50 or Dv50 - Dn50 becomes excessively large, this indicates that the number of small-diameter particles is excessively high, which undesirably increases the surface area of the active material that is in contact with the electrolyte. As a result, gas generation due to side reactions may increase.

More specifically, the volume-based median particle diameter (Dv50) of the lithium transition-metal oxide may be from 3.5 to 4.5 $\mu$m. When Dv50 is too small, the electrode calendaring density may decrease, thereby degrading the electrode energy density. Conversely, when Dv50 is too large, the crystallite size and particle size become excessively large, increasing the lithium-ion diffusion length and thereby degrading capacity and output characteristics. As will be described later with respect to the manufacturing method, the particle-size distribution of the lithium transition-metal oxide is ultimately determined by adjusting the conditions of the crushing step, and when Dv50 is controlled within the above range during crushing, the material properties defined in Equation 1 and Equation 2 can be more easily satisfied.

In addition, the number-based median particle diameter (Dn50) of the lithium transition-metal oxide may be 1 $\mu$m or less. When Dn50 satisfies this range, not only can the electrode energy density and capacity be improved, but the high-temperature lifetime characteristics can also be enhanced.

Meanwhile, the crystallite size of the lithium transition-metal oxide may be 190 nm or less, and more specifically may be 185 nm or less. In the present specification, the term "crystallite" refers to a distinct region within a primary particle in which atoms form a lattice structure oriented in a specific direction, and the "crystallite size" may be estimated from the peak broadening of XRD data and quantitatively calculated using the Scherrer equation.

In general, as the crystallite size of a lithium transition-metal oxide increases, the lifetime characteristics tend to improve, whereas the capacity characteristics tend to deteriorate. In contrast, the positive electrode active material according to the present invention exhibits improved high-temperature lifetime characteristics even when the crystallite size is reduced. Consequently, when the crystallite size of the lithium transition-metal oxide satisfies the above range, both the capacity improvement effect resulting from reduced crystallite size and the high-temperature lifetime improvement effect can be simultaneously achieved. This is believed to be due to the sufficiently large c-axis lattice constant of the lithium transition-metal oxide according to the present invention, which facilitates lithium-ion intercalation and thereby reduces irreversible reactions, as will be described later.

Meanwhile, the ratio of the c-axis lattice constant to the a-axis lattice constant (Lc/La) of the lithium transition-metal oxide may be 4.955 or greater, and more specifically may be 4.9553 or greater. Satisfying this range indicates that the c-axis lattice constant is sufficiently larger than the a-axis lattice constant, thereby ensuring that a layered structure is well formed within the lithium transition-metal oxide and promoting lithium-ion intercalation. As a result, the capacity and initial efficiency of the battery can be improved.

More specifically, the c-axis lattice constant (Lc) of the lithium transition-metal oxide may be 14.2472 nm or greater. In addition, the a-axis lattice constant (La) may be 2.8752 nm or less.

The lithium transition-metal oxide may be expressed more specifically by the following Chemical Formula 1.

[Chemical Formula 1]     $Li_a[Ni_xCo_yMn_zM_w]O_2$

In Chemical Formula 1, $0.8 \leq a \leq 1.2$, $0.5 \leq x \leq 0.7$, $0 \leq y \leq 0.2$, $0 \leq z \leq 0.4$, $0 \leq w \leq 0.2$, and $x + y + z + w = 1$, and M is at least one selected from the group consisting of Zr, Al, B, Y, Mg, Ti, Nb, W, Sc, Si, V, Fe, Y, Mo, Ce, Hf, Ta, La, Sr, and combinations thereof.

In the lithium transition-metal oxide of Chemical Formula 1, lithium may be present in an amount corresponding to a, that is, $0.8 \leq a \leq 1.2$. If a is too small, the capacity may deteriorate; if a is too large, the strength of the calcined active material may increase such that comminution becomes difficult, and the amount of lithium residuals may increase, thereby causing increased gas generation. Considering the improvement in capacity associated with lithium content control and the balance of sinterability during active material fabrication, lithium may preferably be included in an amount of $0.9 \leq a \leq 1.1$.

In the lithium transition-metal oxide of Chemical Formula 1, nickel may be included in an amount corresponding to x, that is, $0.5 \leq x \leq 0.7$. If the nickel content is too low, achieving high capacity becomes difficult, whereas if the nickel content is too high, structural stability of the active material may deteriorate, resulting in reduced cycle life and thermal safety of the battery, and manufacturing cost may increase.

In the lithium transition-metal oxide of Chemical Formula 1, cobalt may be included in an amount corresponding to y, that is, $0 \leq y \leq 0.2$, or more specifically $0.05 \leq y \leq 0.2$. If the cobalt content is too low, it may be difficult to simultaneously achieve sufficient rate capability and high powder density. If the cobalt content is too high, raw material cost increases and the reversible capacity may decrease.

In the lithium transition-metal oxide of Chemical Formula 1, manganese may be included in an amount corresponding to z, that is, $0 \leq z \leq 0.4$, or more specifically $0.1 \leq z \leq 0.4$. If the manganese content is too low, manufacturing cost may increase and the stability of the active material may be reduced. If the manganese content is too high, the capacity and output characteristics of the battery may deteriorate.

In the lithium transition-metal oxide of Chemical Formula 1, M may be included in an amount corresponding to w, that is, $0 \leq w \leq 0.2$. Here, M is a dopant element and may be selected from Zr, Al, B, Y, Mg, Ti, Nb, W, Sc, Si, V, Fe, Y, Mo, Ce, Hf, Ta, La, Sr, or combinations thereof.

## 2. Method for Manufacturing the Positive Electrode Active Material

According to another embodiment of the present invention, a method for manufacturing a positive electrode active material for a lithium secondary battery is provided, the method comprising: preparing a transition metal precursor containing from 50 mol% to 70 mol% of nickel based on a total moles of transition metals; mixing the transition metal precursor with a lithium raw material, followed by performing a first calcination and a second calcination to form a lithium transition metal oxide; and performing a first crushing and a second crushing on the lithium transition metal oxide to form a single-particle lithium transition metal oxide, wherein the second calcination is performed in an oxygen ($O_2$) atmosphere.

A step-by-step description of the manufacturing method according to this embodiment is provided below.

First, a transition metal precursor containing from 50 mol% to 70 mol% of nickel based on a total moles of transition metals is prepared.

The transition metal precursor may be a transition metal hydroxide.

The transition metal hydroxide may be produced, for example, by adding a chelating-agent-containing solution and a pH-adjusting-agent-containing solution to a transition-metal-containing solution including a nickel raw material and optionally a cobalt raw material or a manganese raw material, and then conducting a co-precipitation reaction.

The nickel raw material is not particularly limited so long as it is a material commonly used in the art for preparing precursors of positive electrode active materials. For example, the nickel raw material may include a nickel-containing sulfate, acetate, nitrate, halide, sulfide, hydroxide, oxide, or oxyhydroxide. Specific examples include $NiSO_4$, $NiSO_4 \cdot 6H_2O$, $Ni(OH)_2$, $NiO$, $NiOOH$, $NiCO_3 \cdot 2Ni(OH)_2 \cdot 4H_2O$, $NiC_2O_2 \cdot 2H_2O$, $Ni(NO_3)_2 \cdot 6H_2O$, nickel fatty-acid salts, nickel halides, and combinations thereof, but are not limited thereto.

The cobalt raw material is not particularly limited so long as it is a material used in the art for preparing precursors of positive electrode active materials. Examples include cobalt-containing sulfates, acetates, nitrates, halides, sulfides, hydroxides, oxides, or oxyhydroxides. Specific examples include $CoSO_4$, $CoSO_4 \cdot 7H_2O$, $Co(OH)_2$, $CoOOH$, $Co(O-COCH_3)_2 \cdot 4H_2O$, $Co(NO_3)_2 \cdot 6H_2O$, and combinations thereof, but are not limited thereto.

The manganese raw material is also not particularly limited and may include manganese-containing sulfates, acetates, nitrates, halides, sulfides, hydroxides, oxides, oxyhydroxides, or combinations thereof. Specific examples include $MnSO_4$, $MnCO_3$, $Mn(NO_3)_2$, manganese acetate, manganese dicarboxylate salts, manganese citrate, manganese fatty-acid salts, $Mn_2O_3$, $MnO_2$, $Mn_3O_4$, manganese oxyhydroxides, manganese chloride, and combinations thereof, but are not limited thereto.

The transition-metal-containing solution may be prepared by dissolving the nickel raw material and optionally the cobalt raw material or the manganese raw material in a solvent such as water or a mixture of water with an organic solvent miscible with water (e.g., an alcohol).

The chelating-agent-containing solution serves to form complexes and may include, for example, $NH_3$, $NH_4OH$, $(NH_4)_2SO_4$, $NH_4NO_3$, $NH_4Cl$, $CH_3COONH_4$, $NH_4CO_3$, or combinations thereof. The chelating-agent-containing solution may be used in the form of an aqueous solution, where the solvent is water or a mixture of water with a water-miscible organic solvent.

The pH-adjusting-agent-containing solution serves as a precipitating agent or pH adjuster, and may include an alkaline compound such as NaOH, KOH, or $Ca(OH)_2$, their hydrates, or combinations thereof. This solution may also be used as an aqueous solution. The amount of the pH-adjusting-agent-containing solution added may be such that the pH of the reaction solution becomes 11 to 13.

The co-precipitation reaction may be performed under an inert atmosphere such as nitrogen or argon, at a temperature of 30°C to 70°C, and at a pH of 11 to 13.

Through the above process, particles of nickel-cobalt-manganese (and optionally a doping element) hydroxide are formed and precipitated in the reaction solution. The precipitated precursor particles may be separated, washed, and dried by conventional methods to obtain the precursor. The precursor may be a secondary particle in which primary particles are agglomerated.

By adjusting the concentrations of the nickel raw material, cobalt raw material, and manganese raw material, the molar ratios of nickel, cobalt, and manganese in the precursor can be controlled. Accordingly, the content of nickel in the transition metal precursor may be from 50 mol% to 70 mol% based on a total moles of transition metals. The technical significance of controlling the nickel content is as previously described.

Next, the transition metal precursor and the lithium raw material are mixed, followed by a first calcination and a second calcination to form a lithium transition metal oxide.

In the related art, a single-particle lithium transition metal oxide has typically been formed through only a high-temperature, long-duration first calcination. However, such a method causes a deterioration in electrochemical properties due to cation mixing of nickel and the formation of rocksalt impurity phases resulting from over-sintering. In contrast, the manufacturing method according to the present invention divides the calcination into two steps, thereby preventing such issues, improving particle strength of the active material, and increasing production yield.

In the first calcination, the atmosphere is not particularly limited. For example, the first calcination may be performed in an air atmosphere or in an oxygen ($O_2$) atmosphere, but more specifically may be performed in an air atmosphere. For high-nickel cathode compositions, performing calcination in air generally results in insufficient layered structure formation, leading to significant deterioration in electrochemical performance, and thus oxygen atmospheres are typically employed. However, in the present invention, where the nickel content is relatively lower, performing the first calcination in air does not cause significant degradation in electrochemical characteristics, and manufacturing cost can be reduced.

The second calcination is performed in an oxygen ($O_2$) atmosphere. More specifically, the oxygen atmosphere may have an oxygen partial pressure of 90%, 95%, 97%, or 99% or greater. Through the second calcination in an oxygen atmosphere, the proportion of fine particles generated during subsequent crushing can be appropriately increased, thereby enabling the resulting positive electrode active material to satisfy the physical properties described in Equation 1. This is believed to be because the particle strength of the lithium transition metal oxide obtained via second calcination in an oxygen atmosphere becomes lower than that obtained via second calcination in an air atmosphere. Unlike the prior art, which sought to improve cycle life by simply increasing particle strength, the present invention forms a lithium transition metal oxide having somewhat reduced particle strength and subsequently adjusts the fine-particle fraction through crushing, thereby simultaneously improving both capacity and cycle life.

Each of the first calcination and the second calcination may be independently performed at a temperature of 900°C to 960°C. If the temperatures of the first and second calcination are too low, it may be difficult to form a single-particle lithium transition metal oxide. If the temperatures are too high, over-sintering may occur, leading to degradation in electrochemical properties such as capacity.

The first calcination may be performed for 2 hours to 6 hours. If the first calcination time is too short, lithium ions may not be fully inserted into the precursor. If the first calcination time is too long, over-sintering may occur, making crushing difficult and reducing production throughput.

The second calcination may be performed for 7 hours to 14 hours. If the second calcination time is too short, the desired single-particle morphology may not be sufficiently achieved, and annealing may be insufficient to fully develop the layered structure, resulting in inferior electrochemical performance. If the second calcination time is too long, over-sintering may cause capacity degradation.

Next, the lithium transition metal oxide is subjected to a first crushing and a second crushing to form a single-particle lithium transition metal oxide.

By dividing the crushing into the first and second crushing steps, the agglomerated secondary particles can be efficiently broken apart into single particles, and the fraction of fine particles can be increased such that the resulting positive electrode active material satisfies the physical properties described in Equation 1 or Equation 2.

The first crushing may be performed using a crushing apparatus commonly used in the art. For example, the first crushing may be performed using a rotor mill, but is not limited thereto. The first crushing may be performed at a stirring speed of 15,000 rpm to 20,000 rpm. When the stirring speed is within this range, the first crushing can be performed with appropriate force, allowing the fraction of fine particles to be properly controlled so that the resulting active material satisfies the physical properties described in Equation 1.

The second crushing may also be performed using a conventional crushing apparatus. For example, the second crushing may be performed using a jet mill, but is not limited thereto. The second crushing may be controlled such that the volume-based average particle diameter (Dv50) of the lithium transition metal oxide becomes 3.5 $\mu$m to 4.5 $\mu$m. When the Dv50 value is controlled within this range, the resulting active material can more easily satisfy the physical properties described in Equation 1.

The second crushing may be performed at a pulverizing pressure of 3.5 bar to 4.5 bar, more specifically at a pulverizing pressure of 3.5 bar to 3.9 bar. When the pulverizing pressure is within this range, the second crushing can be performed with appropriate force, allowing the fine-particle fraction to be properly controlled such that the resulting active material satisfies the physical properties described in Equation 1.

Through the series of manufacturing steps described above, a single-particle lithium transition metal oxide according to the present invention can be formed, and the obtained lithium transition metal oxide can satisfy the physical properties of Equation 1. Accordingly, the electrode energy density can be improved, and the capacity and high-temperature cycle life of the battery can be enhanced.

## 3. Positive Electrode and Lithium Secondary Battery

According to another embodiment of the present invention, a positive electrode for a lithium secondary battery is provided, the positive electrode comprising the positive electrode active material described above.

More specifically, the positive electrode may include a positive electrode current collector and a positive electrode active material layer disposed on the positive electrode current collector, the positive electrode active material layer comprising the positive electrode active material described above. The positive electrode current collector is not particularly limited so long as it has electrical conductivity and does not cause chemical changes in the battery. Examples thereof include stainless steel, aluminum, nickel, titanium, baked carbon, or aluminum or stainless steel whose surface is treated with carbon, nickel, titanium, silver, or the like. The positive electrode current collector may typically have a thickness of 3 $\mu$m to 500 $\mu$m, and fine surface roughness may be formed on the current collector surface to increase adhesion to the positive electrode active material. For example, the current collector may be in the form of a film, sheet, foil, net, porous body, foam, or nonwoven fabric.

The positive electrode active material layer may further include a binder and/or a conductive agent in addition to the positive electrode active material described above. The binder serves to improve adhesion between active material particles and adhesion between the active material and the current collector. Examples of suitable binders include polyvinylidene fluoride (PVDF), vinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, polytetrafluoroethylene, polyethylene, polypropylene, ethylenepropylene-diene monomer rubber (EPDM rubber), sulfonated EPDM, styrene-butadiene rubber (SBR), fluororubber, and various copolymers thereof. One or more of these may be used. The binder may be included in an amount of 1 wt% to 30 wt% based on the total weight of the positive electrode active material layer.

The conductive agent imparts electrical conductivity to the electrode, and any material that does not cause chemical changes in the battery and has electronic conductivity may be used without particular limitation. Examples include carbon materials such as natural graphite and artificial graphite; carbon black, acetylene black, Ketjen black, channel black, furnace black, lamp black, thermal black, carbon fibers; metal powders or metal fibers such as copper, nickel, aluminum, and silver; conductive whiskers such as zinc oxide or potassium titanate; conductive metal oxides such as titanium oxide; and conductive polymers such as polyphenylene derivatives. One or more of these may be used, and the conductive agent may be included in an amount of 1 wt% to 30 wt% based on the total weight of the positive electrode active material layer.

Except for the use of the positive electrode active material described above, the positive electrode may be manufactured according to conventional methods. Specifically, the positive electrode may be manufactured by applying a composition for forming the positive electrode active material layer-comprising the positive electrode active material and, optionally, a binder, a conductive agent, and a solvent-onto the positive electrode current collector, followed by drying and rolling. Examples of suitable solvents include those generally used in the art, such as dimethyl sulfoxide (DMSO), isopropyl alcohol, N-methyl-2-pyrrolidone (NMP), acetone, or water, alone or in combination. The solvent may be used in an amount sufficient to dissolve or disperse the active material, binder, and conductive agent and to provide a viscosity suitable for uniform coating thickness. Alternatively, the positive electrode may be manufactured by casting the composition onto a separate support, peeling off the resulting film, and laminating the film onto the current collector.

According to another embodiment of the present invention, a lithium secondary battery comprising the positive electrode described above is provided. The lithium secondary battery may include a positive electrode, a negative electrode, a separator, and an electrolyte. The battery may further include a battery case accommodating an electrode assembly of the positive electrode, negative electrode, and separator, and a sealing member for sealing the battery case.

The negative electrode may include a negative electrode current collector and a negative electrode active material layer disposed on the negative electrode current collector. The negative electrode current collector is not particularly limited so long as it has high electrical conductivity and does not cause chemical changes in the battery. Examples include copper, stainless steel, aluminum, nickel, titanium, baked carbon, copper or stainless steel whose surface is treated with carbon, nickel, titanium, or silver, and aluminum-cadmium alloys. The negative electrode current collector may typically have a thickness of 3 $\mu$m to 500 $\mu$m. Similar to the positive electrode current collector, surface roughness may be provided to enhance adhesion. The current collector may be in the form of a film, sheet, foil, net, porous body, foam, or nonwoven fabric.

The negative electrode active material layer may include a negative electrode active material and, optionally, a binder and a conductive agent. The layer may be formed by coating a composition containing the negative electrode active material and optionally a binder and conductive agent onto the negative electrode current collector and drying, or by casting the composition onto a separate support, peeling off the resulting film, and laminating it onto the current collector.

The negative electrode active material may include any material capable of reversible intercalation and deintercalation of lithium. Examples include carbonaceous materials such as artificial graphite, natural graphite, graphitized carbon fibers, and amorphous carbon; metal compounds capable of alloying with lithium such as Si, Al, Sn, Pb, Zn, Bi, In, Mg, Ga, Cd, Si alloys, Sn alloys, or Al alloys; metal oxides capable of doping and dedoping lithium such as SiO$\beta$ (0 < $\beta$ < 2), SnO$_2$, vanadium oxides, and lithium vanadium oxides; and composites including metal compounds and carbon materials such as Si-C composites or Sn-C composites. One or more of these materials may be used. A metal lithium thin film may also be used. Carbon materials may include both low-crystallinity carbon (e.g., soft carbon and hard carbon) and high-crystallinity carbon (e.g., natural graphite, artificial graphite, Kish graphite, pyrolytic carbon, mesophase pitch-based carbon fiber, mesocarbon microbeads, mesophase pitches, and petroleum or coal-tar pitch-derived cokes). The binder and conductive agent may be the same as those described above for the positive electrode.

The separator separates the negative electrode and the positive electrode and provides a path for lithium-ion transport. Any separator conventionally used in lithium secondary batteries may be used without limitation, and it is preferable that the separator exhibit low resistance to ion transport and excellent electrolyte wettability. Examples include porous polymer films made of polyolefin-based materials such as polyethylene homopolymers, polypropylene homopolymers, ethylene/butene copolymers, ethylene/hexene copolymers, and ethylene/methacrylate copolymers, including laminated structures of two or more layers. Porous nonwoven fabrics such as glass fiber or polyethylene terephthalate fiber may also be used. In addition, ceramic-coated or polymer-coated separators may be used to ensure heat resistance or mechanical strength, and these coatings may be applied in single-layer or multilayer form.

The electrolyte may be an organic liquid electrolyte, inorganic liquid electrolyte, solid polymer electrolyte, gel polymer electrolyte, solid inorganic electrolyte, or molten inorganic electrolyte, without limitation. More specifically, the organic liquid electrolyte may include an organic solvent and a lithium salt. Examples of organic solvents include ester-based solvents such as methyl acetate, ethyl acetate, $\gamma$-butyrolactone, and $\varepsilon$-caprolactone; ether-based solvents such as dibutyl ether and tetrahydrofuran; ketone-based solvents such as cyclohexanone; aromatic hydrocarbon-based solvents such as benzene and fluorobenzene; carbonate-based solvents such as dimethyl carbonate (DMC), diethyl carbonate (DEC), methyl ethyl carbonate (MEC), ethyl methyl carbonate (EMC), ethylene carbonate (EC), and propylene carbonate (PC); alcohol solvents such as ethanol or isopropyl alcohol; nitriles such as R-CN (R is a $C_2$-$C_{20}$ hydrocarbon group which may include a double bond, an aromatic ring, or an ether bond); amides such as dimethylformamide; dioxolanes such as 1,3-dioxolane; and sulfolane compounds.

Carbonate-based solvents are preferable; a mixture of a cyclic carbonate (e.g., EC or PC) and a linear carbonate (e.g., EMC, DMC, or DEC) is more preferable. A volume ratio of the cyclic carbonate to the linear carbonate of about 1:1 to about 1:9 may provide excellent electrolyte performance.

The lithium salt may be any compound capable of providing lithium ions in a lithium secondary battery. Examples include LiPF$_6$, LiClO$_4$, LiAsF$_6$, LiBF$_4$, LiSbF$_6$, LiAlO$_4$, LiAlCl$_4$, LiCF$_3$SO$_3$, LiC$_4$F$_9$SO$_3$, LiN(C$_2$F$_5$SO$_3$)$_2$, LiN(C$_2$F$_5$SO$_2$)$_2$, LiN(CF$_3$SO$_2$)$_2$, LiCl, LiI, and LiB(C$_2$O$_4$)$_2$. The lithium salt concentration may preferably be 0.1 M to 2.0 M, enabling suitable conductivity, viscosity, and ion mobility.

The electrolyte may further include one or more additives intended to improve cycle life, suppress capacity decline, or enhance discharge capacity. Examples include haloalkylene carbonates such as difluoroethylene carbonate, pyridine, triethyl phosphite, triethanolamine, cyclic ethers, ethylenediamine, n-glyme, hexamethylphosphoric triamide, nitrobenzene derivatives, sulfur, quinone imine dyes, N-substituted oxazolidinones, N,N-substituted imidazolidines, ethylene glycol dialkyl ethers, ammonium salts, pyrrole, 2-methoxy ethanol, and aluminum trichloride. These additives may be included at 0.1 wt% to 5 wt% based on the total weight of the electrolyte.

A lithium secondary battery including the positive electrode active material of the present invention exhibits excellent discharge capacity, output characteristics, and capacity retention, making it useful for portable electronic devices such as mobile phones, notebook computers, and digital cameras, and for electric vehicle applications such as hybrid electric vehicles (HEVs).

Accordingly, another embodiment of the present invention provides a battery module including the lithium secondary battery as a unit cell, and a battery pack including the battery module. The battery module or battery pack may be used as a power source for medium-to-large-scale devices such as power tools; electric vehicles (EVs), hybrid electric vehicles, and plug-in hybrid electric vehicles (PHEVs); or power storage systems.

The following examples describe embodiments of the invention in further detail. However, the examples are provided merely for illustrative purposes, and the invention is not limited thereto.

**Examples**

**Example 1**

**(1) Preparation of the Positive Electrode Active Material**

(Mixing) A transition metal precursor having a composition of $Ni_{0.6}Co_{0.1}Mn_{0.3}(OH)_2$ was charged into a mixer together with $LiOH \cdot H_2O$ in an amount such that a molar ratio (Li/M) of lithium to total transition metals of the precursor became 1.07, followed by mechanical mixing to form a mixture.

(First Calcination) The mixture was then heated under an air atmosphere to 940°C and calcined at the same temperature for 4 hours, followed by natural cooling. Thereafter, the first-calcined material was crushed using a rotor mill.

(Second Calcination) The crushed first-calcined material was then subjected to a second calcination under an oxygen atmosphere having an oxygen partial pressure of 99% at 940°C for 10 hours, followed by natural cooling to form a lithium transition metal oxide.

(First Crushing) The resulting lithium transition metal oxide was subjected to a first crushing step using a rotor mill at a stirring speed of 17,000 rpm.

(Second Crushing) Subsequently, a second crushing was carried out using a jet mill at a pulverizing pressure of 3.7 bar to form a single-particle lithium transition metal oxide.

The final composition of the obtained lithium transition metal oxide was $Li_{1.07}Ni_{0.6}Co_{0.1}Mn_{0.3}O_2$.

**(2) Preparation of the Lithium Secondary Battery**

A slurry for electrode fabrication was prepared by mixing the above-prepared positive electrode active material, a conductive agent (carbon black, Denka Black), and a binder (PVDF, KF9700) at a weight ratio of 95.0 : 2.0 : 3.0 wt%. N-methyl-2-pyrrolidone (NMP) was added to adjust the viscosity so that the solid content became about 60%.

The prepared slurry was coated onto a 20-$\mu$m-thick aluminum foil using a doctor blade, followed by drying and rolling. The electrode loading was 16.0 mg/cm$^2$, and the rolling density (25°C, 20 kN) was 3.5 g/cm$^3$.

As the electrolyte, a solution of 1 M $LiPF_6$ in EC:DMC:DEC = 1:2:1 (vol%) containing 2.0 vol% of vinylene carbonate (VC) based on the total electrolyte volume was used. A coin cell was assembled using a polypropylene separator (PP) and a lithium metal negative electrode (400 $\mu$m, Niba metal).

**Example 2**

In Example 2, the same procedure as in Example 1 was performed except that the second calcination was carried out for 11 hours.

**Comparative Example 1**

Comparative Example 1 was prepared in the same manner as Example 1, except that (i) the second calcination was conducted under an air atmosphere having an oxygen partial pressure of 21%, and (ii) the second crushing was performed using a jet mill at a pulverizing pressure of 4.1 bar.

**Comparative Example 2**

Comparative Example 2 was prepared in the same manner as Example 1, except that (i) the second calcination was conducted under an air atmosphere (oxygen partial pressure: 21%) for 9 hours, and (ii) the second crushing was performed using a jet mill at a pulverizing pressure of 4.1 bar.

**Comparative Example 3**

Comparative Example 3 was prepared in the same manner as Example 1, except that (i) the second calcination was conducted under an air atmosphere (oxygen partial pressure: 21%) for 8 hours, and (ii) the second crushing was performed using a jet mill at a pulverizing pressure of 4.0 bar.

**Experimental Example 1: SEM Images of the Positive Electrode Active Materials**

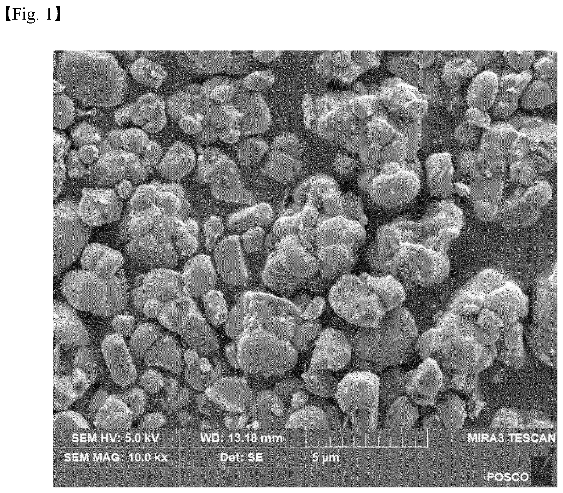

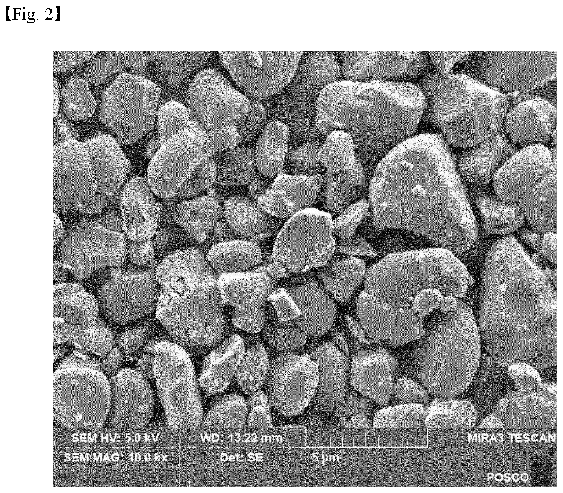

SEM images of the positive electrode active materials prepared according to Example 1 and Comparative Example 1 were obtained, and are shown in FIGS. 1 and 2, respectively.

Referring to FIGS. 1 and 2, it was confirmed that both Example and Comparative Example active materials exhibit a single-particle morphology.

**Experimental Example 2: Evaluation of Physical Properties of the Positive Electrode Active Materials**

The physical properties of the positive electrode active materials of the Examples and Comparative Examples were evaluated as follows, and the results are shown in Table 2.

**(1) Evaluation of Dv50, Dn50, Dv50/Dn50, and Dv50 - Dn50**

The volume-based average particle diameter (Dv50) was measured using a laser diffraction method, by determining the particle diameter corresponding to 50% of the cumulative volume.

The number-based average particle diameter (Dn50) was measured by determining the particle diameter corresponding to 50% of the cumulative number.

Dv50/Dn50 and Dv50 - Dn50 were then calculated using these values.

**(2) Evaluation of Crystallite Size, a-Axis Lattice Constant (La), c-Axis Lattice Constant (Lc), and Lc/La**

XRD data of the active materials were obtained using a D8 Discover with GADDS (Bruker), and the crystallite size, a-axis lattice constant (La), and c-axis lattice constant (Lc) were determined by Rietveld refinement using the DIFFRAC.TOPAS software (Bruker).

The ratio (Lc/La) was obtained by dividing the c-axis lattice constant (Lc) by the a-axis lattice constant (La).

[Table 1]

| | Processing Conditions | | | | |
| --- | --- | --- | --- | --- | --- |
| | First Calcination | Second Calcination | Atmosphere of Second Calcination | First Crushing | Second Crushing |
| C-Ex. 1 | 940°C, 4h, air | 940°C, 10h | Air (O$_2$ partial pressure: 21%) | Rotor mill - 17000rpm | Jet mill - 4.1bar |
| C-Ex. 2 | | 940°C, 9h | Air (O$_2$ partial pressure: 21%) | Rotor mill - 17000rpm | Jet mill - 4.1bar |
| C-Ex. 3 | | 940°C, 8h | Air (O$_2$ partial pressure: 21%) | Rotor mill - 17000rpm | Jet mill - 4.0bar |
| Ex. 1 | | 940°C, 10h | O$_2$ (O$_2$ partial pressure: 99%) | Rotor mill - 17000rpm | Jet mill - 3.7bar |
| Ex. 2 | | 940°C, 11h | O$_2$ (O$_2$ partial pressure: 99%) | Rotor mill - 17000rpm | Jet mill - 3.7bar |

[Table 2]

| | Particle size | | | |
| --- | --- | --- | --- | --- |
| | Dv50 (um) | Dn50 (um) | Dv50 / Dn50 | Dv50 - Dn50 (um) |
| C-Ex. 1 | 3.99 | 2.8 | 1.42 | 1.19 |
| C-Ex. 2 | 3.98 | 2.79 | 1.42 | 1.19 |
| C-Ex. 3 | 3.86 | 2.52 | 1.53 | 1.34 |
| Ex. 1 | 4.03 | 0.89 | 4.54 | 3.14 |
| Ex. 2 | 3.99 | 0.9 | 4.43 | 3.09 |

[Table 3]

| | XRD | | | |
|---|---|---|---|---|
| | Crystal Size (nm) | a-aixs (Å) | c-aixs (Å) | Lc/La |
| C-Ex. 1 | 210 | 2.8753 | 14.2456 | 4.9545 |
| C-Ex. 2 | 208 | 2.8755 | 14.2463 | 4.9544 |
| C-Ex. 3 | 200 | 2.8755 | 14.247 | 4.9546 |
| Ex. 1 | 181 | 2.8751 | 14.2475 | 4.9555 |
| Ex. 2 | 183 | 2.875 | 14.2473 | 4.9556 |

Referring to Tables 1 to 3, in Examples 1 and 2, in which the manufacturing process conditions of the positive electrode active material-such as performing the second calcination in an oxygen atmosphere and performing the second crushing-were appropriately controlled, it was confirmed that the values of Dv50/Dn50, Dv50 - Dn50, and other XRD properties were obtained within the ranges according to the present invention.

In contrast, in Comparative Examples 1 to 3, in which the second calcination was performed in an air atmosphere, it was confirmed that the values of Dv50/Dn50, Dv50 - Dn50, and other XRD properties fell outside the ranges according to the present invention.

**Experimental Example 3: Evaluation of Electrochemical Properties of Lithium Secondary Batteries**

The electrochemical properties of the lithium secondary batteries of the Examples and Comparative Examples were evaluated using the following methods, and the results are shown in Table 4.

**(1) Evaluation of Initial Capacity and Initial Efficiency**

A lithium secondary battery half-cell was fabricated, aged for 12 hours at 25°C, and then subjected to charge/discharge testing at 25°C.

To evaluate the initial capacity, charging was performed to 4.4 V at a constant current of 0.1C based on a reference capacity of 200 mAh/g, followed by constant-voltage charging until the cut-off current reached 0.05C.

After charging, the cell was rested for 10 minutes, and then discharged to 2.5 V at a constant current of 0.1C based on the same reference capacity of 200 mAh/g.

**(2) Evaluation of High-Temperature Cycle Life (Capacity Retention at 45°C, 50 cycles)**

A lithium secondary battery half-cell was fabricated and cycled at 45°C.

Charging was performed to 4.4 V at a constant current of 0.5C, followed by constant-voltage charging until the cut-off current reached 0.05C. After charging, the cell was rested for 10 minutes, and then discharged to 2.5 V at a constant current of 1.0C. This charge/discharge cycle was repeated 50 times, and the capacity retention was calculated by comparing the discharge capacity of the 50th cycle with that of the 1st cycle.

**(3) Evaluation of High-Temperature Resistance Increase Rate (45°C, 50 cycles)**

A lithium secondary battery half-cell was fabricated and cycled at 45°C under the same charge/discharge conditions described above. Charging was performed to 4.4 V at 0.5C, followed by constant-voltage charging until the cut-off current reached 0.05C. After a 10-minute rest time, the cell was discharged to 2.5 V at a constant current of 1.0C. The cycle was repeated 50 times, and the resistance increase rate was calculated by comparing the internal resistance of the 50th cycle with that of the 1st cycle.

[Table 4]

| | 0.1C/0.1C Initial Cycle | | | High-Temp.test | |
|---|---|---|---|---|---|
| | Charge (mAh/g) | Discharge (mAh/g) | Efficiency (%) | Retention @50th | ΔDCIR @50th |
| C-Ex. 1 | 213.6 | 191.8 | 89.80% | 94.20% | 154.30% |
| C-Ex. 2 | 213.4 | 191.5 | 89.70% | 94.10% | 154.20% |

(continued)

| | 0.1C/0.1C Initial Cycle | | | High-Temp.test | |
|---|---|---|---|---|---|
| | Charge (mAh/g) | Discharge (mAh/g) | Efficiency (%) | Retention @50th | ΔDCIR @50th |
| C-Ex. 3 | 213.6 | 191.7 | 89.70% | 94.30% | 155.70% |
| Ex. 1 | 214 | 193.7 | 90.50% | 94.90% | 134.20% |
| Ex. 2 | 213.7 | 193.7 | 90.70% | 94.90% | 135.10% |

Referring to Table 4, in Examples 1 and 2, in which the physical properties of the positive electrode active material such as those defined in Equation 1 were within the ranges according to the present invention, it was confirmed that the initial charge capacity, discharge capacity, initial efficiency, high-temperature cycle life characteristics, and high-temperature resistance characteristics were all excellent.

In contrast, in Comparative Examples 1 to 3, in which the physical properties of the positive electrode active material such as those defined in Equation 1 fell outside the ranges according to the present invention, the initial charge capacity, discharge capacity, initial efficiency, high-temperature cycle life characteristics, and high-temperature resistance characteristics were inferior compared to those of the Examples.

Although preferred embodiments of the present invention have been described above, the present invention is not limited thereto, and various modifications may be made within the scope of the appended claims, the detailed description, and the accompanying drawings. Accordingly, the true scope of the present invention shall be defined by the appended claims and equivalents thereof.

## Claims

1. A positive electrode active material for a lithium secondary battery, comprising:

   a single-particle lithium transition metal oxide containing from 50 mol% to 70 mol% of nickel based on a total moles of transition metals,
   wherein the positive electrode active material satisfies Equation 1 below.

   [Equation 1]

   $$Dv50 / Dn50 \geq 3.0$$

   In Equation 1, Dv50 is a volume-based average particle diameter of the positive electrode active material, and Dn50 is a number-based average particle diameter of the positive electrode active material.

2. The positive electrode active material of claim 1, wherein the positive electrode active material satisfies Equation 2 below.

   [Equation 2]

   $$Dv50 - Dn50 \geq 2.5 \text{ nm}$$

   In Equation 2, Dv50 is a volume-based average particle diameter of the positive electrode active material, and Dn50 is a number-based average particle diameter of the positive electrode active material.

3. The positive electrode active material of claim 1, wherein the volume-based average particle diameter (Dv50) of the lithium transition metal oxide is from 3.5 $\mu$m to 4.5 $\mu$m.

4. The positive electrode active material of claim 1, wherein the number-based average particle diameter (Dn50) of the lithium transition metal oxide is 1 $\mu$m or less.

5. The positive electrode active material of claim 1, wherein a crystallite size of the lithium transition metal oxide is 190 nm or less.

6. The positive electrode active material of claim 1, wherein a ratio (Lc/La) of a lattice constant of a c-axis (Lc) to a lattice constant of an a-axis (La) of the lithium transition metal oxide is 4.955 or greater.

7. The positive electrode active material of claim 1, wherein the lattice constant of the c-axis (Lc) of the lithium transition metal oxide is 14.2472 nm or greater.

8. The positive electrode active material of claim 1, wherein the lattice constant of the a-axis (La) of the lithium transition metal oxide is 2.8752 nm or less.

9. The positive electrode active material of claim 1, wherein the lithium transition metal oxide is represented by Chemical Formula 1 below:

[Chemical Formula 1]     $Li_a[Ni_xCo_yMn_zM_w]O_2$

where $0.8 \leq a \leq 1.2$, $0.5 \leq x \leq 0.7$, $0 \leq y \leq 0.2$, $0 \leq z \leq 0.4$, $0 \leq w \leq 0.2$, and $x + y + z + w = 1$; and M is at least one element selected from Zr, Al, B, Y, Mg, Ti, Nb, W, Sc, Si, V, Fe, Y, Mo, Ce, Hf, Ta, La, Sr, and combinations thereof.

10. A method for manufacturing a positive electrode active material for a lithium secondary battery, the method comprising:

preparing a transition metal precursor containing from 50 mol% to 70 mol% of nickel based on a total moles of transition metals;
mixing the transition metal precursor with a lithium raw material, followed by a first calcination and a second calcination to form a lithium transition metal oxide; and
performing a first crushing and a second crushing on the lithium transition metal oxide to form a single-particle lithium transition metal oxide,
wherein the second calcination is performed in an oxygen ($O_2$) atmosphere.

11. The method of claim 10, wherein the second crushing is performed such that a volume-based average particle diameter (Dv50) of the lithium transition metal oxide becomes 3.5 $\mu$m to 4.5 $\mu$m.

12. The method of claim 10, wherein the first crushing is performed at a stirring speed of 15,000 rpm to 20,000 rpm.

13. The method of claim 10, wherein the second crushing is performed at a pulverizing pressure of 3.5 bar to 4.5 bar.

14. The method of claim 10, wherein the first calcination is performed in an air atmosphere.

15. The method of claim 10, wherein each of the first calcination and the second calcination is independently performed at a temperature of 900°C to 960°C.

16. A positive electrode for a lithium secondary battery, comprising the positive electrode active material according to any one of claims 1 to 9.

17. A lithium secondary battery comprising the positive electrode of claim 16.

【Fig. 1】

【Fig. 2】

## INTERNATIONAL SEARCH REPORT

| | International application No. |
|---|---|
| | **PCT/KR2024/010985** |

| A. | CLASSIFICATION OF SUBJECT MATTER |
|---|---|

**H01M 4/525**(2010.01)i; **H01M 4/131**(2010.01)i; **H01M 4/1391**(2010.01)i; **C01G 53/00**(2006.01)i; **H01M 10/052**(2010.01)i; **C30B 29/22**(2006.01)i

According to International Patent Classification (IPC) or to both national classification and IPC

| B. | FIELDS SEARCHED |
|---|---|

Minimum documentation searched (classification system followed by classification symbols)

H01M 4/525(2010.01); C01B 25/45(2006.01); C01G 53/00(2006.01); H01M 10/052(2010.01); H01M 10/0525(2010.01); H01M 4/13(2010.01); H01M 4/136(2010.01); H01M 4/505(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 양극 활물질(cathode active material), 니켈(nickel), 부피 기준 평균 입경 (Dv50), 개수 기준 평균 입경(Dn50), 소성(sinter), 해쇄(crush), 산소(oxygen)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 7202393 B2 (UMICORE et al.) 11 January 2023 (2023-01-11)<br>See claims 1, 4 and 13; and paragraphs [0001], [0047], [0057], [0058], [0082] and [0097]-[0108]. | 1-17 |
| X | CN 115483393 A (SUNWODA ELECTRIC VEHICLE CELL CO., LTD.) 16 December 2022 (2022-12-16)<br>See claims 1-6, 8 and 9; paragraphs [0036], [0038], [0043], [0055]-[0060] and [0077]; and table 2. | 1-4,9,16,17 |
| A | CN 115472898 A (SUNWODA ELECTRIC VEHICLE CELL CO., LTD.) 13 December 2022 (2022-12-13)<br>See claims 3 and 6. | 1-17 |
| A | KR 10-2020-0047117 A (LG CHEM, LTD.) 07 May 2020 (2020-05-07)<br>See claims 1-18. | 1-17 |

☑ Further documents are listed in the continuation of Box C.  ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **25 November 2024** | **25 November 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

International application No.

**PCT/KR2024/010985**

**C.    DOCUMENTS CONSIDERED TO BE RELEVANT**

| Category* | Citation of document, with indication, where appropriate, of the relevant passages | Relevant to claim No. |
|---|---|---|
| A | JP 5002872 B2 (TOYOTA MOTOR CORP.) 15 August 2012 (2012-08-15)<br>See claims 1-7. | 1-17 |
| A | CN 113800493 A (EVE ENERGY CO., LTD.) 17 December 2021 (2021-12-17)<br>See claims 1-10. | 1-17 |

Form PCT/ISA/210 (second sheet) (July 2022)

**INTERNATIONAL SEARCH REPORT**
**Information on patent family members**

International application No.

**PCT/KR2024/010985**

| Patent document cited in search report | | | Publication date (day/month/year) | Patent family member(s) | | | Publication date (day/month/year) |
|---|---|---|---|---|---|---|---|
| JP | 7202393 | B2 | 11 January 2023 | CN | 112004779 | A | 27 November 2020 |
| | | | | CN | 112004779 | B | 07 February 2023 |
| | | | | EP | 3774661 | A1 | 17 February 2021 |
| | | | | EP | 3774661 | B1 | 27 July 2022 |
| | | | | JP | 2021-517721 | A | 26 July 2021 |
| | | | | KR | 10-2020-0138795 | A | 10 December 2020 |
| | | | | KR | 10-2481574 | B1 | 26 December 2022 |
| | | | | US | 2021-0143423 | A1 | 13 May 2021 |
| | | | | WO | 2019-185349 | A1 | 03 October 2019 |
| CN | 115483393 | A | 16 December 2022 | None | | | |
| CN | 115472898 | A | 13 December 2022 | CN | 115472898 | B | 15 September 2023 |
| | | | | EP | 4383390 | A1 | 12 June 2024 |
| | | | | US | 2024-0222685 | A1 | 04 July 2024 |
| | | | | WO | 2024-087388 | A1 | 02 May 2024 |
| KR | 10-2020-0047117 | A | 07 May 2020 | US | 12040484 | B2 | 16 July 2024 |
| | | | | US | 2020-0136141 | A1 | 30 April 2020 |
| | | | | US | 2024-0313210 | A1 | 19 September 2024 |
| JP | 5002872 | B2 | 15 August 2012 | JP | 2003-059489 | A | 28 February 2003 |
| CN | 113800493 | A | 17 December 2021 | None | | | |

Form PCT/ISA/210 (patent family annex) (July 2022)